# EUROPEAN PATENT APPLICATION

(11) **EP 4 586 304 A1**
(43) Date of publication of application: **16.07.2025**
(21) Application number: 25151176.2
(22) Date of filing: 10.01.2025
(51) Int. Cl.: H01L 21/02, H01L 21/265

(54) **IMPLANTATION PROCESS TO MITIGATE BOWING OF WAFERS INTRODUCED BY SPLITTING PROCESS**

(30) Priority: 12.01.2024 US 202463620479 P; 16.12.2024 US 202418982737
(71) Applicant: II-VI Delaware, Inc., Wilmington, DE 19890 (US)
(72) Inventor: TURCAUD, Jeremy, Wilmington, 19890 (US); LEE, Dong, Wilmington, 19890 (US); ROSSMAN, Dennis, Wilmington, 19890 (US); LUCCHESI, Greg, Wilmington, 19890 (US); CHAN, Ben, Wilmington, 19890 (US)
(74) Representative: Schmidt, Christian

(57) **Abstract**

Methods of forming a crystalline wafers such as silicon carbide wafers are disclosed. Such a method may include providing a crystalline substrate comprising a substrate first surface and a substrate second surface opposite the substrate first surface. The method may also include creating a separation layer at a first depth from the substrate first surface and creating a mitigation layer at a second depth from a substrate second surface. Creating the separation layer may cause the crystalline substrate to bow, and creating the mitigation layer may reduce the bow of the crystalline substrate. The method may further include separating the wafer from the crystalline substrate along the separation layer.

## Description

### CLAIM OF PRIORITY

This patent application claims priority to and claims benefit from United States Provisional Patent Application Serial No. 63/620,479, filed on January 12, 2024, which is hereby incorporated herein by reference in its entirety.

### BACKGROUND

Crystalline substrates such as silicon carbide (SiC) substrates may constitute a significant portion of the overall cost of manufacturing a semiconductor device. One option for reducing such costs is to split a wafer from a crystalline substrate and produce semiconductor devices from the wafer split from the crystalline substrate. Further wafers may be split from the crystalline substrate and further semiconductor devices may be produced from such wafers. In this manner, the costs associated with a single crystalline substrate may be spread across a greater number of semiconductor devices and reduce the average cost of manufacturing a semiconductor device. While wafer splitting may result in a greater device yield from a single substrate, wafer splitting may cause bowing (*i.e*., surface curvature) of the wafer. Such bowing may further complicate subsequent process integration steps.

### BRIEF SUMMARY OF THE DISCLOSURE

Shown in and/or described in connection with at least one of the figures, and set forth more completely in the claims are processes for mitigating bowing of wafers split from the crystalline substrate.

These and other advantages, aspects and novel features of the present disclosure, as well as details of illustrated embodiments thereof, will be more fully understood from the following description and drawings.

### BRIEF DESCRIPTION OF THE DRAWINGS

Various features and advantages of the present disclosure may be more readily understood with reference to the following detailed description taken in conjunction with the accompanying drawings, wherein like reference numerals designate like structural elements.
FIG. 1 depicts a flowchart of a process for mitigating bowing of a substrate in accordance with various aspects of the present disclosure.
FIG. 2 depicts cross-sectional views of the substrate of the FIG. 1 process at various stages.
FIG. 3 depicts a graph of vacancies versus depths for ionic species at respective implanted energies and dosages.

### DESCRIPTION

The following discussion provides various examples of mitigating bowing of substrates and/or wafers split from such substrates. Such examples are non-limiting, and the scope of the appended claims should not be limited to the particular examples disclosed. In the following discussion, the terms "example" and "*e.g*." are non-limiting.

The figures illustrate the general manner of construction, and descriptions and details of well-known features and techniques may be omitted to avoid unnecessarily obscuring the present disclosure. In addition, elements in the drawing figures are not necessarily drawn to scale. For example, the dimensions of some of the elements in the figures may be exaggerated relative to other elements to help improve understanding of the examples discussed in the present disclosure. The same reference numerals in different figures denote the same elements.

The term "and/or" means any one or more of the items in the list joined by "and/or". As an example, "x and/or y" means any element of the three-element set {(x), (y), (x, y)}. As another example, "x, y, and/or z" means any element of the seven-element set {(x), (y), (z), (x, y), (x, z), (y, z), (x, y, z)}.

The terms "comprises," "comprising," "includes," and/or "including," are "open ended" terms and specify the presence of stated features, but do not preclude the presence or addition of one or more other features.

The terms "first," "second," *etc.* may be used herein to describe various elements, and these elements should not be limited by these terms. These terms are only used to distinguish one element from another. Thus, for example, a first element discussed in this disclosure could be termed a second element without departing from the teachings of the present disclosure.

Unless specified otherwise, the term "coupled" may be used to describe two elements directly contacting each other or describe two elements indirectly connected by one or more other elements. For example, if element A is coupled to element B, then element A can be directly contacting element B or indirectly connected to element B by an intervening element C. Similarly, the terms "over" or "on" may be used to describe two elements directly contacting each other or describe two elements indirectly connected by one or more other elements.

Generally, aspects of the present disclosure are directed to processes for mitigating bowing of wafers or films split from a crystalline substrate. In some embodiments, the process may implant a cleaving ionic species into a crystalline substrate to a first depth from a substrate first surface. The implantation of the cleaving ionic species may cause bowing of the crystalline substrate and/or the attached wafer. To mitigate such bowing, the process may implant a non-cleaving ionic species into the crystalline substrate to a second depth from the substrate second surface.

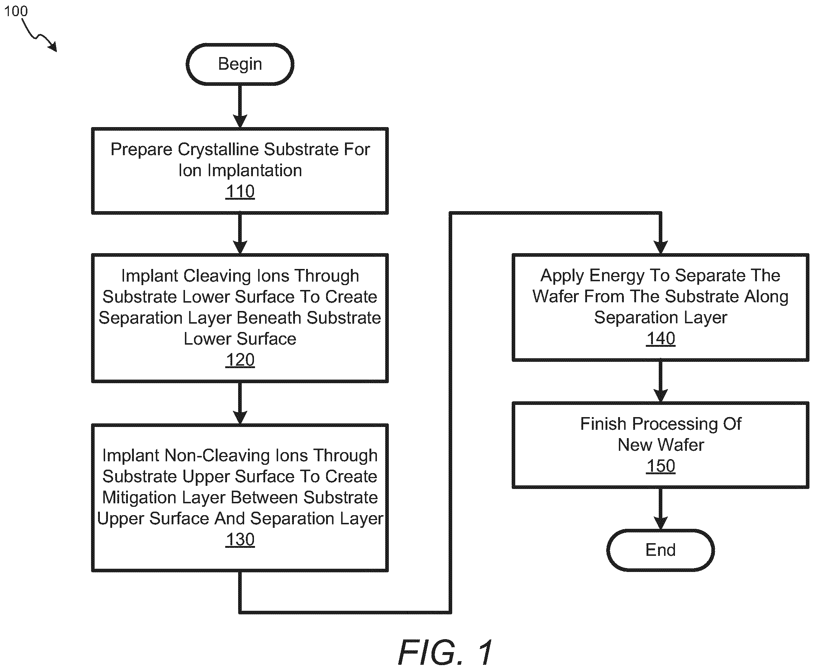

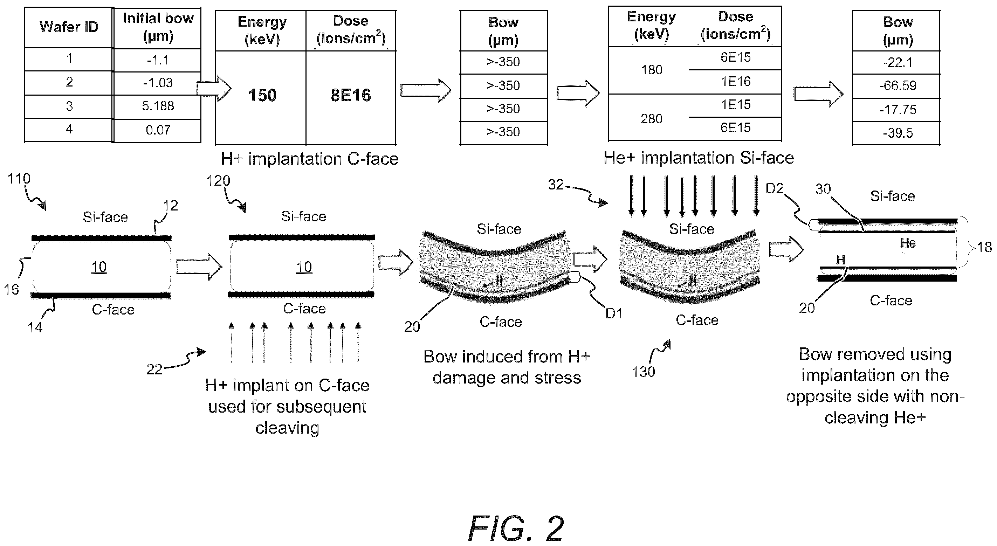

Referring now to FIGS. 1 and 2, a process 100 of mitigating bowing of a wafer split from a crystalline substrate is shown. While the process 100 is shown and described below in regard to splitting silicon carbide (SiC) wafers or films from a silicon carbide substrate, the process 100 may be used to form crystalline wafers or films from crystalline substrate materials other than silicon carbide.

At 110, the process 100 may prepare a silicon carbide substrate 10 for ion implantation. The silicon carbide substrate 10 may comprise a single crystalline structure defining a substrate upper surface 12, a substrate lower surface 14, and a substrate lateral surface 16 between the substrate upper surface 12 and the substrate lower surface 14. The single crystal structure of the silicon carbide substrate 10 may exhibit one of many silicon carbide polymorphs such as, for example, 3C-SiC, 4C-SiC, 6H-SiC, *etc.* Further, the substrate upper surface 12 may correspond to the Si-face of the silicon carbide substrate 10 and the substrate lower surface 14 may correspond to the C-face of the silicon carbide substrate 10. At 110, the substrate upper surface 12 may be polished to remove surface defects in the single crystalline structure of the silicon carbide substrate 10 due to, for example, prior splitting of a wafer from the silicon carbide substrate 10.

Despite such preparation, the substrate upper surface 12 may not be completely planar. FIG. 2 shows four example wafers (*i.e*., wafer 1, wafer 2, wafer 3, and wafer 4). Wafer 1 has an initial bow of -1.1 µm (*i.e*., slightly concave), wafer 2 has an initial bow of -1.03 µm (*i.e*., slightly concave), wafer 3 has an initial bow of 5.188 µm (*i.e*., slightly convex), and wafer 4 has an initial bow of 0.07 (*i.e*., slightly convex).

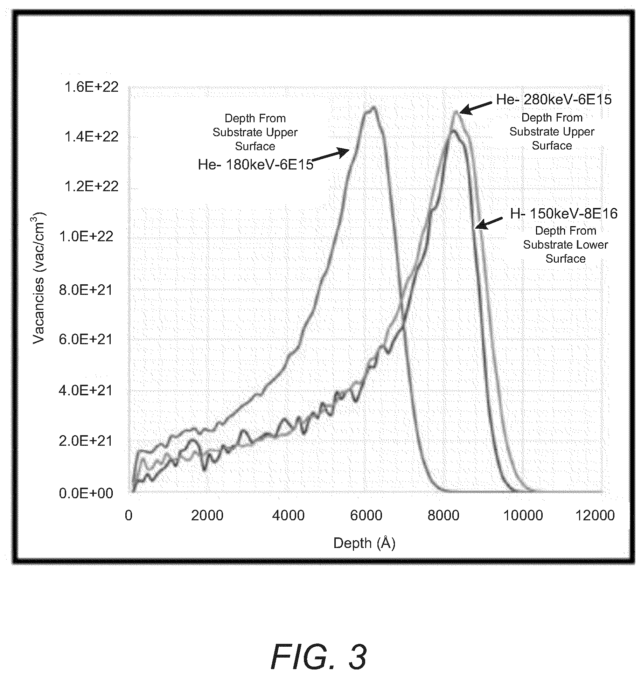

At 120, the process 100 may create a separation layer 20 at a desired depth D1 from the substrate lower surface 14. To this end, cleaving ions 22 may be implanted through the C-face or substrate lower surface 14 to the desired depth D1 in the silicon carbide substrate 10. Such implanting may damage the crystalline structure (*e.g*., create bond vacancies in the crystalline structure) of the silicon carbide substrate 10. Various cleaving ionic species may be implanted depending on the crystalline material of the substrate. In particular, for silicon carbide, hydrogen (H) ions may be used as the cleaving ions 22. The depth that such hydrogen (H) ions are implanted into the substrate lower surface 14 is dependent upon the implantation energy. See, FIGS. 2 and 3. Further, the amount of damage (*e.g*., created vacancies) may be dependent upon the quantity or dosage of hydrogen (H) ions implanted.

As shown in the FIG. 2, hydrogen (H) ions in the depicted embodiment may be implanted using an implant energy 150 kiloelectronvolts (keV) at a dosage of 8e16 ions/cm². However, as noted above, the implant energy controls the depth of the implant and the dosage controls the amount of damage or quantity of vacancies introduced to the crystalline structure. As such, the above values are merely exemplary. Other embodiments may adjust these values based on the desired depth of implant, the ionic species implanted, the crystalline material receiving the implant, *etc.*

As shown in FIG. 3, the vacancies resulting from the implanted ions are distributed across a range of depths and not simply at one single depth. In particular, FIG. 3 depicts hydrogen (H) ions implanted and an implant energy 150 keV and a dosage of 8e16 ions/cm². Such an implantation of hydrogen (H) ions may result in a peak concentration implantation depth of roughly 6400 Å with roughly 1.6e22 vacancies/cm³.

Furthermore, as shown in FIG. 2, the creation of the separation layer 20 may subject the crystalline structure of the silicon carbide substrate 10 to stresses that bow the substrate upper surface 12. In the example of FIG. 2, where hydrogen (H) ions are implanted at an implant energy 150 keV and a dosage of 8e16 ions/cm², each wafer 1, 2, 3, 4 may develop a bow greater than -350 µm (i.e., significantly convex).

At 130, the process 100 may create a mitigation layer 30 at a desired depth D2 from the substrate upper surface 12. To this end, non-cleaving ions 32 may be implanted through the Si-face or substrate upper surface 12 to the desired depth D2 in the silicon carbide substrate 10. Such implanting may damage the crystalline structure (*e.g.*, create bond vacancies in the crystalline structure) of the silicon carbide substrate 10. Various non-cleaving ionic species may be implanted depending on the crystalline material of the substrate. In particular, for silicon carbide, helium (He) ions may be used as the non-cleaving ions 32. The depth that such helium (He) ions are implanted into the substrate upper surface 12 is dependent upon the implantation energy. See, FIGS. 2 and 3. Further, the amount of damage (*e.g*., created vacancies) may be dependent upon the quantity or dosage of helium (He) ions implanted.

As shown in the FIG. 2, the process 100 may implant helium (He) ions in wafer 1 using an implant energy 180 keV and a dosage of 6e15 ions/cm² and implant helium (He) ions in wafer 2 using an implant energy 180 keV and a dosage or 1e16 ions/cm². Further, the process 100 may implant helium (He) ions in wafer 3 using an implant energy 280 keV and a dosage of 1e15 ions/cm² and implant helium (He) ions in wafer 4 using an implant energy 280 keV and a dosage or 6e15 ions/cm². As noted above, the implant energy controls the depth of the implant and the dosage controls the amount of damage or quantity of vacancies introduced to the crystalline structure. As such, the above values are merely exemplary of particular embodiments. Moreover, the values are selected based, at least in part, on the amount of bow to be countered by the mitigation layer 30.

As shown in FIG. 3, the vacancies resulting from the implanted ions are distributed across a range of depths and not simply at one single depth. In particular, FIG. 3 depicts helium (He) ions implanted at an implant energy 180 keV and a dosage of 6e15 ions/cm² and helium (He) ions implanted at an implant energy 280 keV and a dosage of 6e15 ions/cm². As shown, the implant at 180 keV may result in a peak concentration implantation depth of roughly 6400 Å with roughly 1.5e22 vacancies/cm³ and the implant at 280 keV may result in a peak concentration implantation depth of roughly 8400 Å with roughly 1.5e22 vacancies/cm³.

Furthermore, as shown in FIG. 2, the creation of the mitigation layer 30 may subject the crystalline structure of the silicon carbide substrate 10 to stresses that counteract the stresses introduced by the separation layer 20. In particular, the above created mitigation layers 30 may reduce the bow of wafer 1 from greater than -350 µm to -22.1, the bow of wafer 2 from greater than -350 µm to -66.59 µm, the bow of wafer 3 from greater than -350 µm to -17.75 µm, and the bow of wafer 4 from greater than -350 µm to -39.5 µm.

After creating the mitigation layer 30, the process 100 at 140 may separate the wafer 18 from the silicon carbide substrate 10. To this end, the process 100 may subject the silicon carbide substrate 10 to thermal energy to coalesce vacancies or bubbles of the separation layer 20 and separate the wafer 18 from the silicon carbide substrate 10. In particular, the amount of energy required to coalesce vacancies of the separation layer 20 is much less than the energy required to coalesce vacancies of the mitigation layer 30. This difference in energy is due to the ionic species selected to form the separation layer 20 and the mitigation layer 30. For example, in the above example, the hydrogen (H) ions are considered a cleaving ionic species for the silicon carbide substrate 10 since a lower amount of energy (*e.g*., 0.35 keV) is required to coalesce each bubble and separate the wafer 18 from the silicon carbide substrate 10. Conversely, the helium (He) ions are considered a non-cleaving ionic species for the silicon carbide substrate 10 since a greater amount of energy (*e.g*., 2.40 keV) is required to coalesce each bubble. Due to this gap in required energies to induce separation, the process 100 at 140 may apply energy (e.g., thermal) to the silicon carbide substrate 10 at a level sufficient to separate the wafer 18 from the silicon carbide substrate 10 along the separation layer 20, but insufficient to further separate along the mitigation layer 30.

At 150, the process 100 may output a silicon carbide wafer or film 18 by finish processing of the separated wafer 18. In particular, the process 100 in some embodiments may polish and/or etch the wafer 18 to remove remnants of the separation layer 20. Such polishing and/or etching may remove and/or reduce defects introduce during the separation of the silicon carbide wafer 18 from the silicon carbide substrate 10.

Moreover, the process 100 may be repeated with the same silicon carbide substrate. In this manner, multiple silicon carbide wafers 18 may be obtained from a single silicon carbide substrate 10.

The present disclosure claims the priority of U.S. application 63/620,479 filed on January 12, 2024 and of U.S. application 18/982,737 filed on December 16, 2024. The entire disclosure of these applications is hereby explicitly incorporated by reference into the present disclosure.

Implementations disclosed herein may relate to the following: Methods of forming a crystalline wafers such as silicon carbide wafers are disclosed. Such a method may include providing a crystalline substrate comprising a substrate first surface and a substrate second surface opposite the substrate first surface. The method may also include creating a separation layer at a first depth from the substrate first surface and creating a mitigation layer at a second depth from a substrate second surface. Creating the separation layer may cause the crystalline substrate to bow, and creating the mitigation layer may reduce the bow of the crystalline substrate. The method may further include separating the wafer from the crystalline substrate along the separation layer.

In the following, a set of aspects is disclosed. The aspects are numbered to facilitate referencing the features of one aspect in other aspects. The aspects form part of the disclosure of the present application and could be made subject to independent and/or dependent claims irrespective of what currently is claimed in the application. The aspects are:
1. A method of forming a wafer, the method comprising:
   providing a crystalline substrate comprising a substrate first surface and a substrate second surface opposite the substrate first surface;
   creating a separation layer at a first depth from the substrate first surface;
   creating a mitigation layer at a second depth from a substrate second surface; and
   separating the wafer from the crystalline substrate along the separation layer.
2. The method of aspect 1, wherein:
   creating the separation layer causes the crystalline substrate to bow; and
   creating the mitigation layer reduces the bow of the crystalline substrate.
3. The method of aspect 1, wherein:
   creating the separation layer comprises implanting cleaving ions into the crystalline substrate; and
   creating the mitigation layer comprises implanting non-cleaving ions into the crystalline substrate.
4. The method of aspect 1, wherein:
   creating the separation layer comprises implanting cleaving ions into the crystalline substrate via the substrate first surface; and
   creating the mitigation layer comprises implanting non-cleaving ions into the crystalline substrate via the substrate second surface.
5. The method of aspect 1, wherein creating the separation layer comprises implanting hydrogen ions into the crystalline substrate.
6. The method of aspect 1, wherein creating the mitigation layer comprises implanting helium ions into the crystalline substrate.
7. The method of aspect 1, wherein separating the wafer from the crystalline substrate comprises applying thermal energy at a level sufficient to coalesce vacancies of the separation layer.
8. The method of aspect 7, wherein the level of the thermal energy is insufficient to coalesce vacancies of the mitigation layer.
9. The method of aspect 1, comprising removing remnants of the separation layer from the wafer.
10. The method of aspect 1, comprising reusing the crystalline substrate, after separating the wafer from the crystalline substrate, to form another wafer.
11. A method of forming a silicon carbide wafer, the method comprising:
   providing a silicon carbide substrate comprising a Si-face and a C-face;
   implanting a cleaving ion species into the C-face of the silicon carbide substrate to form a separation layer;
   implanting a non-cleaving ion species into the Si-face of the silicon carbide substrate to form a mitigation layer that counteracts a bow of the silicon carbide substrate; and
   separating the silicon carbide wafer from the silicon carbide substrate along the separation layer.
12. The method of aspect 11, wherein implanting the cleaving ion species contributes to the bow of the silicon carbide substrate.
13. The method of aspect 11, wherein:
   implanting the cleaving ion species forms the separation layer at a first depth from the C-face of the silicon carbide substrate; and
   implanting the non-cleaving ion species forms the mitigation layer at a second depth from the Si-face of the silicon carbide substrate.
14. The method of aspect 11, wherein implanting the non-cleaving ion species forms the mitigation layer between the Si-face of the silicon carbide substrate and the separation layer.
15. The method of aspect 11, wherein implanting the cleaving ion species comprises implanting hydrogen ions into the silicon carbide substrate.
16. The method of aspect 11, wherein implanting the non-cleaving ion species comprises implanting helium ions into the silicon carbide substrate.
17. The method of aspect 11, wherein separating the silicon carbide wafer from the silicon carbide substrate comprises applying energy at a level sufficient to coalesce vacancies of the separation layer.
18. The method of aspect 17, wherein the level of the energy is insufficient to coalesce vacancies of the mitigation layer.
19. The method of aspect 11, comprising removing remnants of the separation layer from the silicon carbide wafer.
20. The method of aspect 11, comprising reusing the silicon carbide substrate, after separating the silicon carbide wafer from the silicon carbide substrate, to form another silicon carbide wafer.

The present disclosure includes reference to certain examples, however, it will be understood by those skilled in the art that various changes may be made and equivalents may be substituted without departing from the scope of the disclosure. In addition, modifications may be made to the disclosed examples without departing from the scope of the present disclosure. Therefore, it is intended that the present disclosure not be limited to the examples disclosed, but that the disclosure will include all examples falling within the scope of the appended claims.

## Claims

1. A method of forming a wafer, the method comprising:
providing a crystalline substrate comprising a substrate first surface and a substrate second surface opposite the substrate first surface;
creating a separation layer at a first depth from the substrate first surface;
creating a mitigation layer at a second depth from a substrate second surface; and
separating the wafer from the crystalline substrate along the separation layer.

2. The method of claim 1, wherein:
creating the separation layer causes the crystalline substrate to bow; and
creating the mitigation layer reduces the bow of the crystalline substrate.

3. The method of claim 1 or 2, wherein:
creating the separation layer comprises implanting cleaving ions into the crystalline substrate; and
creating the mitigation layer comprises implanting non-cleaving ions into the crystalline substrate.

4. The method of any one of claims 1 to 3, wherein:
creating the separation layer comprises implanting cleaving ions into the crystalline substrate via the substrate first surface; and
creating the mitigation layer comprises implanting non-cleaving ions into the crystalline substrate via the substrate second surface.

5. The method of any one of claims 1 to 4, wherein creating the separation layer comprises implanting hydrogen ions into the crystalline substrate.

6. The method of any one of claims 1 to 5, wherein creating the mitigation layer comprises implanting helium ions into the crystalline substrate.

7. The method of any one of claims 1 to 6, wherein separating the wafer from the crystalline substrate comprises applying thermal energy at a level sufficient to coalesce vacancies of the separation layer.

8. The method of claim 7, wherein the level of the thermal energy is insufficient to coalesce vacancies of the mitigation layer.

9. The method of any one of claims 1 to 8, comprising removing remnants of the separation layer from the wafer.

10. The method of any one of claims 1 to 9, comprising reusing the crystalline substrate, after separating the wafer from the crystalline substrate, to form another wafer.

11. A method of forming a silicon carbide wafer, the method comprising:
providing a silicon carbide substrate comprising a Si-face and a C-face;
implanting a cleaving ion species into the C-face of the silicon carbide substrate to form a separation layer;
implanting a non-cleaving ion species into the Si-face of the silicon carbide substrate to form a mitigation layer that counteracts a bow of the silicon carbide substrate; and
separating the silicon carbide wafer from the silicon carbide substrate along the separation layer.

12. The method of claim 11, wherein implanting the cleaving ion species contributes to the bow of the silicon carbide substrate.

13. The method of claim 11 or 12, wherein:
implanting the cleaving ion species forms the separation layer at a first depth from the C-face of the silicon carbide substrate; and
implanting the non-cleaving ion species forms the mitigation layer at a second depth from the Si-face of the silicon carbide substrate.

14. The method of any one of claims 11 to 13, wherein implanting the non-cleaving ion species forms the mitigation layer between the Si-face of the silicon carbide substrate and the separation layer.

15. The method of any one of claims 11 to 14,
a) wherein implanting the cleaving ion species comprises implanting hydrogen ions into the silicon carbide substrate, and/or
b) wherein implanting the non-cleaving ion species comprises implanting helium ions into the silicon carbide substrate, and/or
c) wherein separating the silicon carbide wafer from the silicon carbide substrate comprises applying energy at a level sufficient to coalesce vacancies of the separation layer, wherein, optionally, the level of the energy is insufficient to coalesce vacancies of the mitigation layer, and/or
d) comprising removing remnants of the separation layer from the silicon carbide wafer, and/or
e) comprising reusing the silicon carbide substrate, after separating the silicon carbide wafer from the silicon carbide substrate, to form another silicon carbide wafer.
